# EUROPÄISCHE PATENTSCHRIFT

(11) **EP 1 038 995 B1**
(45) Veröffentlichungstag und Bekanntmachung des Hinweises auf die Patenterteilung: **08.08.2001**
(21) Anmeldenummer: 00105206.7
(22) Anmeldetag: 13.03.2000
(51) Int. Cl.: C30B 11/00, C30B 11/14, C30B 29/42, C30B 29/40

(54) **Verfahren und Vorrichtung zur Herstellung von Einkristallen**
Process and apparatus for producing single crystals
Procédé et appareillage pour la production des monocristaux

(30) Priorität: 19.03.1999 DE 19912486
(43) Veröffentlichungstag der Anmeldung: 27.09.2000
(73) Patentinhaber: Freiberger Compound Materials GmbH, 09599 Freiberg (DE); FORSCHUNGSZENTRUM JÜLICH GMBH, 52425 Jülich (DE)
(72) Erfinder: Sonnenberg, Klaus, 52382 Niederzier (DE); Küssel, Eckhard, 52353 Düren (DE); Bünger, Thomas, 09131 Chemnitz (DE); Flade, Thilo, 09599 Freiberg (DE); Weinert, Berndt, 09599 Freiberg (DE)
(74) Vertreter: Prüfer, Lutz H., Dipl.-Phys.

(56) Entgegenhaltungen:
- EP-A- 0 671 490
- EP-A- 0 744 476
- PATENT ABSTRACTS OF JAPAN vol. 1995, no. 01, 28. Februar 1995 (1995-02-28) & JP 06 298588 A (DOWA MINING CO LTD), 25. Oktober 1994 (1994-10-25)
- AMON J ET AL: "Analysis of types of residual dislocations in the VGF growth of GaAs with extremely low dislocation density (EPD ?1000cm) - A Tutorial Approach, X-Ray Topographic Techniques for Electronic Materials Characterization" JOURNAL OF CRYSTAL GROWTH,NL,NORTH-HOLLAND PUBLISHING CO. AMSTERDAM, Bd. 198-199, März 1999 (1999-03), Seiten 367-373, XP004170881 ISSN: 0022-0248

## Beschreibung

Die Erfindung betrifft ein Verfahren und eine Vorrichtung zur Herstellung von Einkristallen. Insbesondere betrifft die Erfindung ein Verfahren zur Herstellung von Einkristallen unterschiedlicher Materialien, beispielsweise III-V-Materialien, beispielsweise von Galliumarsenid, mit großem Durchmesser.

Verfahren zur Herstellung von Einkristallen unterschiedlicher Materialien, beispielsweise III-V-Materialien, beispielsweise von Galliumarsenid (GaAs), sind bekannt. Die bekannten Verfahren zur Herstellung unterschiedlicher III-V-Einkristallen haben den Nachteil, daß ein formschlüssiges Einpassen des Kristallkeimes, das für die Vorgabe der Kristallorientierung erforderlich ist, in einem Tiegelbereich mit geringem Durchmesser oft eine Berührung des Kristallkeimes mit der Innenwand des Tiegels zur Folge hat. Dadurch kann die Keimoberfläche nicht ausreichend mit oxidischer Schmelze abgedeckt werden, wodurch ein Abdampfen der Gruppe der V-Komponente erfolgt.

Das abgedampfte Material kondensiert unkontrolliert an kälteren Stellen des Reaktionssystems und kristallisiert dort frei aus. Die Keimoberfläche reichert sich mit der III-wertigen Komponente an, so daß das Einkristallwachstum verhindert wird. Diese freien Kristallite bzw. der zersetzte Keim wirken dann als zusätzliche Kristallisationskeime, die die Ursache für polykristallines Wachstum sind.
Außerdem kann durch eine direkte Berührung des Keimes mit der Tiegelwand es zu einer lokalen Verformung und Zerstörung des Keimes infolge unterschiedlicher Materialausdehnungskoeffizienten durch dabei auftretende Kräfte kommen. Dies tritt ebenfalls auf, wenn die Boroxidschicht nicht flächig und vollständig um den gewachsenen Einkristall gelegt wurde.
Es entsteht eine ungewollte Kristallorientierung und somit ein Totalverlust des geforderten Prozeßergebnisses. Um eine unkontrollierte Kristallorientierung zu vermeiden, ist es erforderlich, den Kristallkeim und den Kristall vollständig mit der oxidischen Schmelze zu bedecken.

Bekannte Verfahren zur Verringerung der Versetzungsdichte beinhalten beispielsweise die Anwendung versetzungsarmer Keime. Solche Keime sind jedoch anfällig gegen thermisch induzierte Spannungen, die die Zerstörung eines Keimes durch zusätzliche Versetzungsbildung verursachen können. Um einen Keim resistenter gegen thermisch induzierte Spannungen zu gestalten, ist folgender Weg vorstellbar. Der Temperaturgradient kann an der Ankeimstelle sehr klein gehalten werden. Dies führt jedoch zu Unsicherheiten bei der Position der Ankeimstelle, bedingt durch auftretende Schwankungen. Außerdem verlängert sich die Prozeßzeit, da man gezwungen ist, die Überhitzung des Reaktionsraumes zur Einbringung der Schmelzwärme des festen Vorlaufmaterials gering zu halten. Mit dem bekannten Verfahren ist die Herstellung von Einkristallen unterschiedlicher III-V-Materialien, wie beispielsweise Galliumarsenid mit großem Durchmesser, beispielsweise 100, 150 oder 200mm, nicht oder nur mit einem unverhältnismäßig hohem Aufwand möglich.

Aus der EP 0 744 476 A2 und aus der EP 0 671 490 A1 ist es bekannt, in einem dem Kristallzüchtungsprozeß vorgelagerten Schritt eine feste Schicht auf die Tiegelinnenwand aufzubringen, die den unmittelbaren Kontakt zwischen dem BN-Tiegel und dem Keim verhindern soll. Es besteht jedoch die Gefahr, daß wenn der Keim in den Tiegel gegeben wird, diese Schicht abplatzt, da sie im allgemeinen nicht sicher verankert werden kann.

Es ist Aufgabe der Erfindung, ein Verfahren und eine Vorrichtung zur Herstellung von Einkristallen unterschiedlicher III-V-Materialien, beispielsweise von Galliumarsenid bereitzustellen, mit dem versetzungsarme Einkristalle mit großem Durchmesser mit hoher Qualität auf einfache Weise hergestellt werden könnten.

Die Aufgabe wird gelöst durch eine Vorrichtung nach Patentanspruch 1 und durch ein Verfahren nach Patentanspruch 8.

Weiterbildungen der Erfindung sind in den Unteransprüchen angegeben.

Das erfindungsgemäße Verfahren und die Vorrichtung sowie der Kristallkeim garantiert die Herstellung von Einkristallen unterschiedlicher III-V-Materialien mit großem Durchmesser und einer hohen Ausbeute. Es ist dadurch möglich, Galliumarsenid-Einkristalle mit einem Durchmesser von 51mm (2"), 76mm (3"), 100mm, 125mm, 150mm, 200mm und größer in guter Qualität herzustellen. Dadurch wird den Herstellern von Halbleiterbauelementen ein Produkt zur Verfügung gestellt, daß die hohen Ansprüche, die an die Halbleiterbauelemente gestellt werden, voll erfüllt. Die Ausbeute bei der Einkristallzüchtung wird durch das erfindungsgemäße Verfahren wesentlich verbessert.

Weitere Merkmale und Zweckmäßigkeiten ergeben sich aus der Beschreibung eines Ausführungsbeispieles anhand der Figuren.

Von den Figuren zeigen:
- Fig. 1: eine schematische Schnittansicht einer Vorrichtung zur Herstellung eines Galliumarsenid-Einkristalles; und
- Fig. 2: eine schematische Schnittansicht des untersten Tiegelbereiches von Fig. 1 mit eingesetztem Kristallkeim.

Die Vorrichtung weist einen Tiegel 1 mit einem oberen Rand 2 und einem bodenseitigen Ende 3 auf. Ferner weist der Tiegel einen zylindrischen ersten Abschnitt 4 auf mit einem Innendurchmesser, der dem Durchmesser des zu züchtenden Einkristalles entspricht und mit einer Länge, die etwa der Länge des zu züchtenden Einkristalles entspricht. Angrenzend an den ersten Abschnitt 4 weist der Tiegel 1 einen sich gegen das bodenseitige Ende 3 konisch verjüngenden zweiten Abschnitt 5, der einen Übergangsbereich bei der Kristallzüchtung bildet, auf. Angrenzend an den zweiten Abschnitt 5 weist der Tiegel 1 einen dritten zylindrischen Abschnitt 6, der einen geringeren Innendurchmesser hat, als der erste Abschnitt 4 und der am Boden geschlossen ist, auf. Der dritte Abschnitt 6 bildet den Keimkanal. Der Innendurchmesser des Keimkanales beträgt etwa 8mm. Der Tiegel ist bevorzugt ein Bornitrid-Tiegel (BN-Tiegel) oder ein pyrolytischer Bornitrid-Tiegel (pBN-Tiegel).

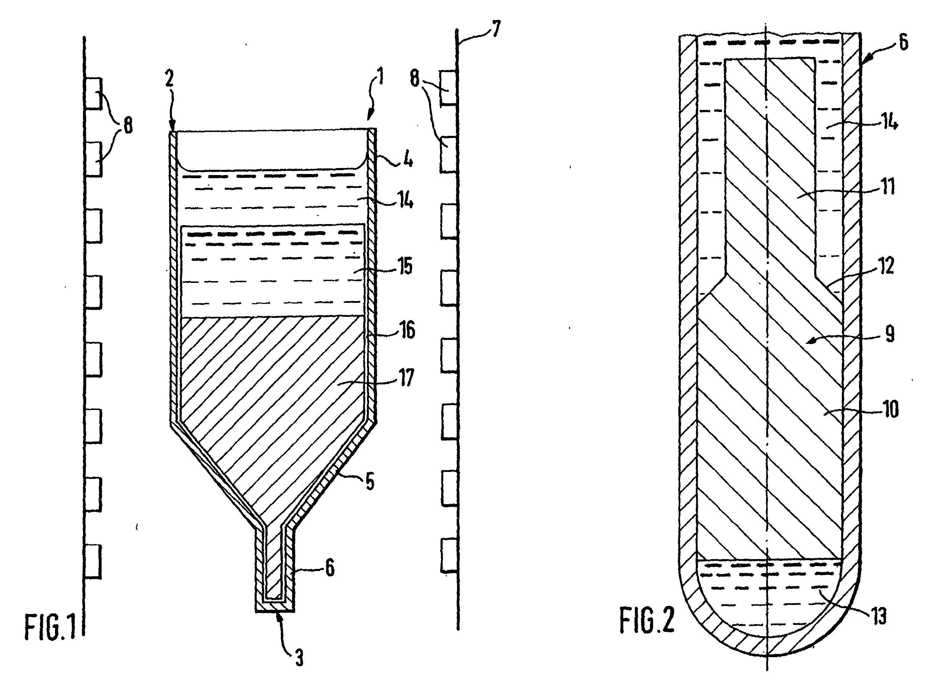

Der Tiegel 1 ist in einem in Fig. 1 schematisch dargestellten Ofen 7 angeordnet. Der Ofen 7 weist eine Mehrzahl von übereinanderliegenden ringförmigen Heizelementen 8 auf, die den Tiegel 1 in vertikaler Richtung vom Keimkanal bis zu seinem oberen Rand umgeben. Es ist eine in Fig. 1 nicht dargestellte Steuerung zum Ansteuern der Heizelemente 8 vorgesehen, die so ausgebildet ist, daß sie die Heizelemente 8 derart ansteuert, daß sich ein vertikaler Temperaturgradient mit einer hohen Temperatur am oberen Rand des Tiegels und einer niedrigeren Temperatur im Bereich des Keimkanals einstellt.

Wie aus Fig. 2 ersichtlich ist, weist ein erfindungsgemäßer Kristallkeim 9 einen ersten zylindrischen Abschnitt 10 auf, mit einem Durchmesser, der so bemessen ist, daß der Kristallkeim spielfrei in den Keimkanal 3 eingesetzt werden kann und einen zweiten zylindrischen Abschnitt 11 mit einem geringeren Durchmesser auf. Vorteilhafterweise ist die Länge des zweiten Abschnittes 11 etwa gleich der Hälfte der Gesamtlänge des Kristallkeimes. Die Gesamtlänge des Kristallkeimes ist etwas kleiner als die Gesamtlänge des Keimkanales. Ein Übergangsbereich 12 zwischen dem ersten Abschnitt 10 und dem zweiten Abschnitt 11 ist bevorzugt konisch ausgebildet. Der Kristallkeim 9 ist derart im Keimkanal angeordnet, daß der zweite Abschnitt mit geringerem Durchmesser die dem zu züchtenden Einkristall zugewandte Seite des Kristallkeimes 9 bildet. Zwischen dem Boden des Keimkanales und dem ersten Abschnitt 10 des Kristallkeimes ist ein geringer Abstand, so daß ein Zwischenraum 13 gebildet ist, der mit Boroxid gefüllt ist.

Weder der BN-Tiegel 1 noch der Kristallkeim 9 wird mit einer extra zusätzlich vor dem eigentlichen Kristallzüchtungsprozeß aufgebrachten Schutzschicht versehen. Ein Abplatzen einer Schutzschicht bei der Präparation ist somit ausgeschlossen.

Der Kristallkeim 9 sitzt mit seinem größeren Durchmesser fest zentrisch und formschlüssig im Keimkanal 6, wodurch ein Anliegen des Kristallkeimes 9 im Bereich des zweiten Abschnittes 11 mit dem kleineren Durchmesser, an dem die Ankeimung erfolgt, unmöglich wird. Ein Verdrücken des Kristallkeimes 9 bei nachfolgenden Prozeßschritten ist somit ausgeschlossen. Dies wird noch dadurch verbessert, daß der Kristallkeim 9 kürzer als der Keimkanal 6 ist und somit unaufgeschmolzene polykristalline Materialien in der Startphase nicht auf dem Kristallkeim 9 drükken können.

Der Kristallkeim 9 ist bevorzugt ein thermoschockresistenter Kristallkeim mit einer hohen Versetzungsdichte von ca. 100000 Versetzungen/cm².

Bei dem erfindungsgemäßen Verfahren wird zuerst ein üblicher zylindrischer Kristallkeim mit einer Länge von etwa 40mm und mit einem Durchmesser von etwa 8mm auf einer Länge von etwa 20mm auf einen Durchmesser von etwa 6mm in dem zweiten Bereich 11 abgedünnt. Anschließend wird der Kristallkeim 9 in den den Keimkanal bildenden dritten Abschnitt 6 des Tiegels eingesetzt. Anschließend wird Boroxid B₂O₃, beispielsweise in Pillenform auf den Kristallkeim 9 gesetzt. Das verwendete B₂O₃ hat einen Wassergehalt von etwa 0 - 2500 ppm. Dann wird polykristallines Galliumarsenid, das Ausgangsmaterial zur Kristallzüchtung, hinzu gegeben.

Beim Züchtungsbeginn befindet sich demnach das. B₂O₃ zwischen dem Kristallkeim 9 und polykristallinem Ausgangsmaterial.

Anschließend werden die Heizelemente 8 derart angesteuert, daß das B₂O₃ und das polykristalline Galliumarsenid aufgeschmolzen werden. Das flüssige B₂O₃ 14 fließt in den Zwischenraum zwischen der Wand des Keimkanales und dem abgedünnten Abschnitt 11 des Kristallkeimes 9 und deckt somit den Kristallkeim in dem für die Züchtung relevanten, dem Ausgangsmaterial zugewandten Bereich des Kristallkeimes ab. Durch die Last des darüberliegenden polykristallinen Galliumarsenids wird das B₂O₃ beim Aufschmelzen sicher zwischen den Keim und die Tiegelwand gedrückt. Während der Aufheizphase und auch während der Züchtung befindet sich ständig flüssiges B₂O₃ 14 zwischen den Kristallkeim und die Keimkanalwand und verhindert das Anlegen des Keimes an die Wandung des Keimkanales. Der Kristallkeim kann dadurch frei im Keimkanal stehen. Da die Anschmelzstelle sich in dem Bereich befindet, in dem der Kristallkeim frei steht, wird durch die Abdeckung der Anschmelzstelle mit B₂O₃ eine partielle Zersetzung des Kristallkeimes an der Anschmelzstelle verhindert und der wachsende Kristall "schwimmt" über den gesamten Züchtungsprozeß im Boroxid, wodurch versetzungsarme Einkristalle hoher Qualität erzeugt werden können.

Während der Aufheizphase des zur Herstellung des Einkristalles benötigten Galliumarsenids wird die Temperatur des Keimes so niedrig gehalten, daß der Keim nicht aufschmilzt. Durch die Steuerung wird eine entsprechende Temperatur im Bereich des Keimkanales eingestellt.

Beim eigentlichen Züchtungsprozeß werden die Heizelemente 8 derart angesteuert, daß die Galliumarsenidschmelze 15, die von der B₂O₃-Schmelze, die eine B₂O₃-Schicht 16 an der Tiegelinnenwand bildet, abgedeckt ist, angrenzend an die Anschmelzstelle, d.h. den zweiten Abschnitt 11 des Kristallkeimes bis zum oberen Rand 2 des Tiegels auskristallisiert. Da das geschmolzene Galliumarsenid eine höhere Dichte aufweist, als das B₂O₃, sammelt sich das B₂O₃ stets über dem Galliumarsenid, wie in Fig. 1 gezeigt ist. Somit wird ein Galliumarsenid-Einkristall 17 gebildet.

Da sich zwischen Kristallkeim 9 und polykristallinem Material im konischen Bereich des Tiegels 1 eine hinreichend große Menge an B₂O₃ befindet, welche weit unterhalb der Schmelztemperatur des GaAs schmilzt, wird durch den hydrostatischen Druck des in der Startphase des Kristallzüchtungsprozesses noch festen, darüber befindlichen GaAs das flüssige B₂O₃ sicher zwischen den verjüngten Abschnitt 11 des Kristallkeimes 9 und den Tiegel und zwischen den noch festen polykristallinen GaAs-Formkörper und den Tiegel 1 gedrückt. Damit wird eine hundertprozentige Einhüllung des verjüngten Abschnitts 11 des Kristallkeimes 9 und des flüssigen GaAs erreicht. Dies führt unter typischen Einkristallzüchtungsbedingungen zu einem hundertprozentigen einkristallinen Wachstum.

Desweiteren schützt in der Startphase das flüssige B₂O₃ im sich verjüngenden konischen Abschnitt 5 des Tiegels den Kristallkeim 9 an der Oberfläche vor termischer Zersetzung, es kann kein As aus dem Kristallkeim 9 aus- bzw. eindampfen, was zu unstöchiometrischen Bereichen führen würde, die Ausgangspunkt von polykristallinem Wachstum wären.

Um eine sichere Ankeimposition zu erreichen, ist es vorteilhaft, den Temperaturgradienten möglichst groß zu halten. Dies bewirkt jedoch sofort eine größere Überhitzung des polykristallinen Materials und der sich daraus bildenden Schmelze, welche durch den thermischen Schock einen Kristallkeim mit geringer Versetzungsdichte schädigt. Die Versetzungsdichte beim Vertical Gradient Freeze-Verfahren kann gegen Null gesenkt werden, wenn der verwendete Kristallkeim 9 thermoschockresistent ist, d.h. sich die Versetzungsdichte beim Ankeimvorgang nicht lokal erhöht.

Überraschenderweise hat eine vorherige gezielte Temperaturbehandlung des Kristallkeimes, so daß dieser etwa 10000-100000 Versetzungen/cm² mit gleichmäßiger Verteilung aufweist, zur Folge, daß es zu keiner unkontrollierten Versetzungsbewegung im Kristallkeim kommt, d.h. daß sich die Versetzungsdichte und die Anordnung der Versetzungen unter dem Einfluß eines über dem Keim liegenden Temperaturgradienten nicht ändert. Durch einen entsprechend gestalteten Temperaturgradienten kann somit aus der Galliumarsenid-Schmelze ein Einkristall mit geringer Versetzungsdichte gebildet werden kann.

Die direkte thermische Belastung des Kristallkeims 9 kann noch vermindert werden durch das dazwischen befindliche flüssige B₂O₃. Es verhindert, daß das überhitzte polykristalline GaAs nicht direkt auf den kühleren Kristallkeim 9 tropfen kann, sondern auf dem Weg durch das flüssige B₂O₃ auf die Keimtemperatur abgekühlt wird.

Das erfindungsgemäße Verfahren kann mit jeder Vorrichtung durchgeführt werden und bei jedem Verfahren eingesetzt werden, bei dem eine B₂O₃-Abdeckschmelze verwendet wird. Die Tiegelform muß nicht notwendigerweise zylindrisch sein, sondern kann auch andere Formen annehmen, beispielsweise mit quadratischem Querschnitt.

## Patentansprüche

1. Vorrichtung zur Herstellung eines Einkristalles durch Abkühlen einer Schmelze eines Rohmaterials für den Einkristall mit einem Tiegel (1) zur Aufnahme der Schmelze mit einem ersten Abschnitt (4) mit einer ersten Querschnittsfläche und mit einem einen Keimkanal bildenden zweiten Abschnitt (6) mit einer zweiten Querschnittsfläche, wobei die zweite Querschnittsfläche kleiner ist, als die erste Querschnittsfläche, dadurch gekennzeichnet, daß ein in dem Tiegel angeordneter Kristallkeim (9) mit einem ersten Abschnitt (10) mit einer ersten Querschnittsfläche und einem zweiten Abschnitt (11) mit einer zweiten Querschnittsfläche, die kleiner ist, als die erste Querschnittsfläche, in dem Keimkanal (6) so angeordnet ist, daß sein zweiter Abschnitt (11) in Richtung des ersten Abschnitts (4) des Tiegels (1) gerichtet ist, und wobei zwischen der Innenwand des Keimkanals und wenigstens dem zweiten Abschnitt (11) des Kristallkeimes (9) ein Zwischenraum besteht, so daß der Kristallkeim (9) mit dem zweiten Abschnitt (11) frei im Keimkanal steht.

2. Vorrichtung nach Anspruch 1, dadurch gekennzeichnet, daß der erste (10) und der zweite (11) Abschnitt des Kristallkeims (9) jeweils zylindrisch mit einem ersten und einem zweiten Durchmesser ausgebildet sind, wobei der zweite Durchmesser kleiner als der erste Durchmesser ist und wobei der erste Durchmesser so bemessen ist, daß der Kristallkeim (9) spielfrei in den Keimkanal (6) einsetzbar ist.

3. Vorrichtung nach Anspruch 1 und 2, dadurch gekennzeichnet, daß zwischen dem ersten (10) und dem zweiten (11) Abschnitt des Kristallkeimes (9) eine dritter (12) Abschnitt vorgesehen ist, in dem der erste Abschnitt (19) in den zweiten Abschnitt (11) übergeht.

4. Vorrichtung nach einem der Ansprüche 1 bis 3, dadurch gekennzeichnet, daß der Kristallkeim eine Versetzungsdichte von etwa 10.000 - 100.000 Versetzungen/cm² aufweist.

5. Vorrichtung nach einem der Ansprüche 1 bis 4, dadurch gekennzeichnet, daß eine Heizeinrichtung (7, 8) mit einer Steuerung vorgesehen ist, die derart ausgebildet ist, daß ein definierter Temperaturgradient zwischen dem zweiten Abschnitt (6) des Behälters (1) und dem ersten Abschnitt (4) erzeugt wird, der den Keim im zweiten Abschnitt (11) zu ca. 50% aufschmilzt.

6. Vorrichtung nach einem der Ansprüche 1 bis 5, dadurch gekennzeichnet, daß der Abschnitt 10 des Kristallkeimes (9) hinreichend lang ist und er dadurch sicher im Keimkanal (6) verankert ist.

7. Vorrichtung nach einem der Ansprüche 1 bis 6, dadurch gekennzeichnet, daß die Gesamtlänge des Kristallkeims (9) etwas kleiner als die Gesamtlänge des Keimkanals (6) ist.

8. Verfahren zur Herstellung von Einkristallen durch Abkühlen einer Schmelze von Rohmaterial (15) unter Verwendung einer Vorrichtung nach einem der Ansprüche 1 bis 7, dadurch gekennzeichnet, daß nur der Zwischenraum zwischen dem Abschnitt (11) des Kristallkeimes (9) mit der geringeren Querschnittsfläche und der Wand des Keimkanals (6) mit einer flüssigen oxidischen Schmelze, z.B. B₂O₃ (14), ausgefüllt wird.

9. Verfahren nach Anspruch 8, dadurch gekennzeichnet, daß ein thermoschockresistenter Kristallkeim verwendet wird.

10. Verfahren nach Anspruch 9, dadurch gekennzeichnet, daß ein thermoschockresistenter Kristallkeim mit einer Versetzungsdichte von etwa 10.000 - 100.000 Versetzungen/cm² verwendet wird.

11. Verfahren nach einem der Ansprüche 8 bis 10, dadurch gekennzeichnet, daß ein Tiegel (5) verwendet wird, der sich angrenzend an den Keimkanal (6) konisch erweitert und daß das zum Züchtungsstart im konischen Teil des Tiegels (5) befindliche Oxid (z.B. B₂O₃) beim Schmelzen den Bereich zwischen der inneren Wand des Keimkanals (6) und dem verjüngten Teil des Keimes (11) vollständig ausfüllt.

12. Verfahren nach einem der Ansprüche 8 bis 11, dadurch gekennzeichnet, daß ein Einkristallkeim und ein entsprechendes Rohmaterial zum Herstellen eines Einkristalls verwendet wird.

13. Verfahren nach einem der Ansprüche 8 bis 12, dadurch gekennzeichnet, daß ein III-V-Verbundhalbleiterkristallkeim und ein III-V-Verbundhalbleiterrohmaterial zum Herstellen eines III-V-Verbundhalbleitereinkristalls verwendet wird.

14. Verfahren nach einem der Ansprüche 8 bis 13, dadurch gekennzeichnet, daß ein Galliumarsenid-Kristallkeim und Galliumarsenid-Rohmaterial zur Herstellung eines Galliumarsenid-Einkristalls verwendet wird.

15. Verfahren zur Herstellung von Einkristallen durch Abkühlen einer Schmelze von Rohmaterial (15) unter Verwendung eines in einem Tiegel (1) mit einem Keimkanal (6) vorgesehenen Kristallkeimes (9), dadurch gekennzeichnet, daß ein thermoschockresistenter Kristallkeim von etwa 10.000 - 100.000 Versetzungen/cm² aufweist, verwendet wird.

16. Verfahren nach Anspruch 15, dadurch gekennzeichnet, daß ein Galliumarsenid-Kristallkeim und Galliumarsenid-Rohmaterial für die Herstellung eines Galliumarsenid-Einkristalls verwendet wird.

## Claims

1. An apparatus for producing a single crystal by cooling a melt of a raw material for the single crystal, having a crucible (1) for receiving the melt which has a first section (4) having a first cross-sectional area and a second section (6) which forms a nucleus channel and has a second cross-sectional area, the second cross-sectional area being smaller than the first cross-sectional area, characterised in that a crystal nucleus (9) arranged in the crucible and having a first section (10) having a first cross-sectional area and a second section (11) having a second cross-sectional area which is smaller than the first cross-sectional area is arranged in the nucleus channel (6) such that its second section (11) is directed in the direction of the first section (4) of the crucible (1), and there being an intermediate space between the inside wall of the nucleus channel and at least the second section (11) of the crystal nucleus (9) such that the crystal nucleus (9) stands freely in the nucleus channel with the second section (11).

2. An apparatus according to Claim 1, characterised in that the first (10) and the second (11) sections of the crystal nucleus (9) are each constructed to be cylindrical and having a first and a second diameter, the second diameter being smaller than the first diameter, and the first diameter being dimensioned such that the crystal nucleus (9) may be inserted into the nucleus channel (6) without play.

3. An apparatus according to Claim 1 and 2, characterised in that between the first (10) and the second (11) sections of the crystal nucleus (9) is provided a third (12) section at which the first section (19) merges into the second section (11).

4. An apparatus according to one of Claims 1 to 3, characterised in that the crystal nucleus has a dislocation density of approximately 10,000 - 100,000 dislocations/cm².

5. An apparatus according to one of Claims 1 to 4, characterised in that a heating device (7, 8) having a control means is provided, which is constructed such that a defined temperature gradient is produced between the second section (6) of the container (1) and the first section (4), which melts the nucleus in the second section (11) by approximately 50%.

6. An apparatus according to one of Claims 1 to 5, characterised in that the section 10 of the crystal nucleus (9) is sufficiently long and is consequently anchored securely in the nucleus channel (6).

7. An apparatus according to one of Claims 1 to 6, characterised in that the overall length of the crystal nucleus (9) is slightly smaller than the overall length of the nucleus channel (6).

8. A process for producing single crystals by cooling a melt of raw material (15) using an apparatus according to one of Claims 1 to 7, characterised in that only the intermediate space between the section (11) of the crystal nucleus (9) having the smaller cross-sectional area and the wall of the nucleus channel (6) is filled with a liquid oxidic melt, for example B₂O₃ (14).

9. A process according to Claim 8, characterised in that a crystal nucleus resistant to thermal shock is used.

10. A process according to Claim 9, characterised in that a crystal nucleus resistant to thermal shock and having a dislocation density of approximately 10,000 - 100,000 dislocations/cm² is used.

11. A process according to one of Claims 8 to 10, characterised in that a crucible (5) is used which widens conically adjacent to the nucleus channel (6), and in that the oxide (e.g. B₂O₃) located in the conical part of the crucible (5) at the start of growing completely fills the region between the inside wall of the nucleus channel (6) and the tapered part of the nucleus (11) during melting.

12. A process according to one of Claims 8 to 11, characterised in that a single crystal nucleus and a corresponding raw material are used to produce a single crystal.

13. A process according to one of Claims 8 to 12, characterised in that a III-V composite semi-conductor crystal nucleus and a III-V composite semi-conductor raw material are used to produce a III-V composite semi-conductor single crystal.

14. A process according to one of Claims 8 to 13, characterised in that a gallium arsenide crystal nucleus and gallium arsenide raw material are used to produce a gallium arsenide single crystal.

15. A process for producing single crystals, by cooling a melt of raw material (15) using a crystal nucleus (9) provided in a crucible (1) having a nucleus channel (6), characterised in that a crystal nudeus resistant to thermal shock and having approximately 10,000 -100,000 dislocations/cm² is used.

16. A process according to Claim 15, characterised in that a gallium arsenide crystal nucleus and gallium arsenide raw material are used to produce a gallium arsenide single crystal.

## Revendications

1. Dispositif pour la production d'un monocristal par refroidissement d'une fusion d'un matériau brut pour le monocristal, avec un creuset (1) destiné à recevoir la fusion, avec une première section (4) avec une première aire de section et une deuxième section (6) formant un canal germinal avec une deuxième aire de section, dans lequel la deuxième aire de section est inférieure à la première aire de section, caractérisé en ce qu'un germe cristallin (9) disposé dans le creuset avec une première section (10) ayant une première aire de section et une deuxième section (11) ayant une deuxième aire de section inférieure à la première aire de section est agencé dans le canal germinal (6) de telle sorte que sa deuxième section (11) est orientée en direction de la première section (4) du creuset (1) et en ce que, entre la paroi interne du canal germinal et au moins la deuxième section (11) du germe cristallin (9), il y a un espace tel que le germe cristallin (9) se trouve avec la deuxième section (11) libre dans le canal germinal.

2. Dispositif selon la revendication 1, caractérisé en ce que la première section (10) et la deuxième section (11) du germe cristallin (9) ont respectivement une forme cylindrique avec un premier et un deuxième diamètre, le deuxième diamètre étant inférieur au premier diamètre et le premier diamètre étant défini de façon que le germe cristallin (9) peut être introduit sans jeu dans le canal germinal (6).

3. Dispositif selon la revendication 1 et la revendication 2, caractérisé en ce que, entre la première section (10) et la deuxième section (11) du germe cristallin (9), il est prévu une troisième section (12) assurant la transition entre la première section (10) et la deuxième section (11).

4. Dispositif selon l'une des revendications 1 à 3, caractérisé en ce que le germe cristallin présente une densité de dislocations d'environ 10 000 à 100 000 dislocations/cm².

5. Dispositif selon l'une des revendications 1 à 4, caractérisé en ce qu'il est prévu un dispositif de chauffage (7, 8) avec une commande, qui est formé de façon à produire entre la deuxième section (6) du contenant (1) et la première section (4) un gradient de température défini qui fait fondre à environ 50% le germe dans la deuxième section (11).

6. Dispositif selon l'une des revendications 1 à 5, caractérisé en ce que la section (10) du germe cristallin (9) est suffisamment longue et ainsi ancrée de manière sûre dans le canal germinal (6).

7. Dispositif selon l'une des revendications 1 à 6, caractérisé en ce que la longueur totale du germe cristallin (9) est un peu plus petite que la longueur totale du canal germinal (6).

8. Procédé pour la production de monocristaux par refroidissement d'une fusion de matériau brut (15) en utilisant le dispositif selon l'une des revendications 1 à 7, caractérisé en ce que seul l'espace intermédiaire entre la section (11) du germe cristallin (9) ayant l'aire de surface la plus petite et la paroi du canal germinal (6) est rempli avec une fusion d'oxyde liquide, par exemple de B₂O₃ (14).

9. Procédé selon la revendication 8, caractérisé en ce que l'on utilise un germe cristallin résistant aux chocs thermiques.

10. Procédé selon la revendication 9, caractérisé en ce que l'on utilise un germe cristallin résistant aux chocs thermiques avec une densité de dislocations d'environ 10 000 à 100 000 dislocations/cm².

11. Procédé selon l'une des revendications 8 à 10, caractérisé en ce que l'on utilise un creuset (5) qui s'élargit avec une forme conique au voisinage du canal germinal (6) et qui, au début du tirage, remplit complètement lors de la fusion la zone entre la paroi interne du canal germinal (6) et la partie rétrécie du germe (11) avec l'oxyde (par exemple du B₂O₃) qui se trouve dans la partie conique du creuset (5).

12. Procédé selon l'une des revendications 8 à 11, caractérisé en ce que l'on utilise un germe monocristallin et un matériau brut correspondant pour la fabrication d'un monocristal.

13. Procédé selon l'une des revendications 8 à 12, caractérisé en ce que l'on utilise un germe cristallin semi-conducteur composite III-V et un matériau brut semi-conducteur composite III-V afin de produire un monocristal semi-conducteur composite III-V.

14. Procédé selon l'une des revendications 8 à 13, caractérisé en ce que l'on utilise un germe cristallin d'arséniure de gallium et un matériau brut d'arséniure de gallium afin de produire un monocristal d'arséniure de gallium.

15. Procédé pour la production de monocristaux par refroidissement d'une fusion de matériau brut (15) en utilisant un germe cristallin (9) prévu dans un creuset (1) avec un canal germinal (6), caractérisé en ce que l'on utilise un germe cristallin résistant aux chocs thermiques avec une densité de dislocations d'environ 10 000 à 100 000 dislocations/cm².

16. Procédé selon la revendication 15, caractérisé en ce que l'on utilise un germe cristallin d'arséniure de gallium et un matériau brut d'arséniure de gallium afin de produire un monocristal d'arséniure de gallium.
